# EUROPÄISCHE PATENTSCHRIFT

(11) **EP 3 028 127 B1**
(45) Veröffentlichungstag und Bekanntmachung des Hinweises auf die Patenterteilung: **21.11.2018**
(21) Anmeldenummer: 14738739.3
(22) Anmeldetag: 08.07.2014
(51) Int. Cl.: G06F 3/044, H03K 17/96

(54) **BERÜHRUNGS- UND/ODER ANNÄHERUNGSEMPFINDLICHE EINGABEVORRICHTUNG**
CONTACT AND/OR PROXIMITY-SENSITIVE INPUT DEVICE
DISPOSITIF D'ENTRÉE SENSIBLE À LA PROXIMITÉ ET/OU AU CONTACT

(30) Priorität: 01.08.2013 DE 102013012886; 21.12.2013 DE 102013022100
(43) Veröffentlichungstag der Anmeldung: 08.06.2016
(73) Patentinhaber: Diehl AKO Stiftung & Co. KG, 88239 Wangen (DE)
(72) Erfinder: HEIMANN, Uwe, 88239 Wangen (DE); PRINZ, Michael, 88299 Leutkirch (DE)
(74) Vertreter: Diehl Patentabteilung
(86) Internationale Anmeldenummer: PCT/EP2014/001870
(87) Internationale Veröffentlichungsnummer: WO 2015/014436

(56) Entgegenhaltungen:
- WO-A1-2011/160960
- DE-U1-202007 006 266
- US-A1- 2010 118 560

## Beschreibung

Die vorliegende Erfindung betrifft eine berührungs- und/oder annäherungsempfindliche Eingabevorrichtung mit einem kapazitiven Funktionsprinzip und insbesondere für ein elektronisches Haushaltsgerät, sowie ein elektronisches Haushaltsgerät mit einer solchen Eingabevorrichtung.

In vielen elektrischen bzw. elektronischen Geräten, insbesondere auch in Haushaltsgeräten wie Herden, Kochfeldern, Mikrowellenöfen, Geschirrspülern, Waschmaschinen, Wäschetrocknern, Kühlschränken und dergleichen, werden häufig berührungs- und/oder annäherungsempfindliche Tastschalter bzw. Berührungs- oder Annäherungsschalter eingesetzt, die durch ein einfaches Berühren oder Annähern durch einen Benutzer zum Beispiel einen bestimmten Schaltvorgang auslösen und/oder eine Geräteeinstellung ändern ("Touch Control").

Im Fall eines kapazitiven Schalters bildet ein kapazitives Sensorelement aus einem elektrisch leitfähigen Material zusammen mit zum Beispiel einem Finger des Benutzers über ein Dielektrikum (häufig in Form einer Abdeckplatte aus einem elektrisch isolierenden Material) dazwischen eine Kapazität, die entsprechend dem Betätigen des Schalters, d.h. dem Berühren oder Nicht-Berühren bzw. Annähern oder Nicht-Annähern eines dem kapazitiven Sensorelement zugeordneten Bedienfeldes variabel ist. Die Veränderung des Kapazitätswertes des kapazitiven Sensorelements wirkt sich entsprechend auf ein Ausgangssignal der Sensorschaltung aus, welches von einer Auswerteelektronik verarbeitet und ausgewertet werden kann, um ggf. eine Betätigung des kapazitiven Schalters zu interpretieren.

Solche kapazitiven, berührungs- und/oder annäherungsempfindlichen Eingabevorrichtungen können als Sensorelement zum Beispiel ein biegsames oder flexibles Flachmaterial in Form einer leitfähig beschichteten Trägerfolie aufweisen, welches einerseits hinter einer elektrisch isolierenden Abdeckplatte angeordnet ist und andererseits in einer Kontaktklemme auf einer Leiterplatte mechanisch gehalten und elektrisch kontaktiert wird, wie dies zum Beispiel in der EP 1 629 330 B1 offenbart ist. Bei der EP 2 045 923 B1 erfolgt die elektrische Verbindung zwischen dem Sensorelement und der Leiterplatte durch eine Z-förmige Kontaktfeder, und im Fall der WO 2011/160960 A1 durch eine C-förmige Kontaktfeder, wobei diese Kontaktfedern in beiden Fällen jeweils direkt hinter dem Bedienfeld positioniert sind.

Die DE 20 2007 006 266 U1 offenbart in diesem Zusammenhang einen Berührungsbildschirm mit einer Glasabdeckplatte, hinter der eine Sensorfolie mit mehreren Sensorelektroden innerhalb eines Erfassungsbereichs und mehreren Verbindungsanschlüssen innerhalb eines Außenrandbereichs angeordnet ist. Neben der Sensorfolie ist hinter der Glasabdeckplatte eine Platine angeordnet, die mit den Verbindungsanschlüssen der Sensorfolie über gefederte elektrische Anschlussstecker verbunden ist.

Die US 2010/0118560 A1 offenbart einen kapazitiven Sensor für ein Mobiltelefon oder dergleichen, bei dem mehrere Erfassungselektroden, Verbindungsdrähte und Kontaktelektroden mit hoher Genauigkeit und ohne Luftspalt auf einer Rückseite eines gebogenen Lichtleiters aufgebracht sind.

Der Erfindung liegt die Aufgabe zugrunde, eine verbesserte berührungs- und/oder annäherungsempfindliche Eingabevorrichtung zu schaffen. Die verbesserte Eingabevorrichtung soll insbesondere auch bei unterschiedlichen Ausgestaltungen von Bedienblenden eine gute Signalausbeute und eine gute elektrische Verbindung zur Auswerteelektronik gewährleisten können.

Diese Aufgabe wird gelöst durch eine berührungs- und/oder annäherungsempfindliche Eingabevorrichtung mit den Merkmalen des Anspruchs 1. Besonders bevorzugte Ausgestaltungen und Weiterbildungen der Erfindung sind Gegenstand der abhängigen Ansprüche.

Die berührungs- und/oder annäherungsempfindliche Eingabevorrichtung der Erfindung weist auf: eine Abdeckplatte mit einem Bedienabschnitt, wobei eine einem Benutzer der Eingabevorrichtung zugewandte Seite des Bedienabschnitts ein Bedienfeld für den Benutzer und eine dem Benutzer abgewandte Seite des Bedienabschnitts eine Sensorebene bildet; wenigstens ein kapazitives Sensorfeld, welches in einer Richtung senkrecht zur Sensorebene auf einer dem Benutzer abgewandten Seite der Abdeckplatte angeordnet ist; eine Trägerplatte, welche in einer Richtung senkrecht zur Sensorebene auf einer dem Benutzer abgewandten Seite des wenigstens einen Sensorfeldes angeordnet ist und auf welcher wenigstens ein elektrisches Kontaktfeld vorgesehen ist; und wenigstens ein elektrisches Kontaktelement, welches zwischen der Trägerplatte und dem wenigstens einen Sensorfeld angeordnet ist, um das wenigstens eine Sensorfeld elektrisch leitend mit dem wenigstens einen elektrischen Kontaktfeld der Trägerplatte zu verbinden. Die Abdeckplatte weist zudem einen Kontaktierungsabschnitt auf, der in einer Richtung der Sensorebene neben dem Bedienabschnitt angeordnet ist und dessen dem Benutzer abgewandte Seite eine Kontaktierungsebene bildet. Ferner ist wenigstens ein elektrisches Kontaktfeld vorgesehen, welches in einer Richtung der Sensorebene neben dem wenigstens einen Sensorfeld im Bereich des Kontaktierungsabschnitts der Abdeckplatte angeordnet ist und elektrisch leitend mit dem wenigstens einen Sensorfeld verbunden ist. Und das wenigstens eine elektrische Kontaktelement das wenigstens eine elektrische Kontaktfeld elektrisch leitend mit dem wenigstens einen elektrischen Kontaktfeld der Trägerplatte verbindet. Das wenigstens eine kapazitive Sensorfeld und das wenigstens eine elektrische Kontaktfeld sind auf einer Sensorfolie vorgesehen, welche in einer Richtung senkrecht zur Sensorebene zwischen der Abdeckplatte und der Trägerplatte angeordnet ist; wobei die durch den Kontaktierungsabschnitt der Abdeckplatte gebildete Kontaktierungsebene parallel zur Trägerplatte verläuft, und das wenigstens eine elektrische Kontaktelement an seiner dem wenigstens einen elektrischen Kontaktfeld der Sensorfolie zugewandten Seite einen Kontaktabschnitt aufweist, der ausgestaltet ist, um in das wenigstens eine elektrische Kontaktfeld der Sensorfolie zumindest teilweise einzudringen und so eine elektrisch leitende Verbindung zu den elektrisch leitfähigen Schichten des Kontaktfelds zu gewährleisten.

Eine Bedienblende zum Beispiel eines elektronischen Haushaltsgerätes kann im Wesentlichen plan ausgeführt sein oder räumlich strukturiert sein (z.B. gebogen, bombiert, etc.). Um eine möglichst gute Signalausbeute zu erzielen, sollten die kapazitiven Sensorfelder der Form der Bedienblende folgen, d.h. möglichst gleichmäßig von ihrer dem Benutzer zugewandten Außenseite beabstandet sein. Andererseits müssen die kapazitiven Sensorfelder elektrisch leitend mit den elektrischen Kontaktfeldern einer Trägerplatte verbunden sein, um an eine Auswerteelektronik angeschlossen zu werden. Bei der erfindungsgemäßen Eingabevorrichtung weist einerseits die Sensorfolie separate kapazitive Sensorfelder und elektrische Kontaktfelder auf und weist andererseits die Abdeckplatte einen Bedienabschnitt und einen Kontaktierungsabschnitt neben dem Bedienabschnitt auf. Durch diese Maßnahme werden die Funktionalitäten der kapazitiven Sensorik und der elektrischen Kontaktierung räumlich getrennt. Als Resultat können sie unabhängig voneinander optimal angepasst werden. So können bei einer beliebigen Gestaltung der Bedienblende eine zuverlässige Sensorik und eine einfache und sichere elektrische Kontaktierung gewährleistet werden. Vorzugsweise können so für die elektrischen Kontaktelemente einfach ausgestaltete Bauteile, insbesondere Standard-Bauteile, wie zum Beispiel einfache Stanz-Biegeteile eingesetzt werden. Die -je nach räumlicher Ausgestaltung der Bedienblende - mehr oder weniger komplexe räumliche Anordnung von Sensorik und Kontaktierung kann in vorteilhafter Weise in die Abdeckplatte verlagert werden, an deren Struktur sich die Sensorfolie einfach anpassen kann. Die Abdeckplatte kann vorzugsweise als ein einfaches Spritzgussteil gefertigt werden. Insgesamt kann die Eingabevorrichtung der Erfindung aus einfachen Bauteilen zusammengebaut werden und dennoch an komplexe räumliche Strukturen adaptiert werden.

Leitfähige Kunststoffe bilden beim Spritzen an der Oberfläche häufig nicht oder schlecht leitende Schichten. Die in den Kunststoff eingebrachten leitfähigen Partikel sind im Granulat homogen verteilt, entmischen sich aber an der Oberfläche bedingt durch die Prozessparameter und Prozessbedingungen. Insbesondere bei elastischen Kontaktelementen bei kleiner Federkraft kann dies ein Problem für die elektrisch leitende Verbindung darstellen. Mit der speziellen Ausgestaltung des Kontaktelements dringt das elektrisch leitende Kontaktelement zumindest teilweise in das Kontaktfeld der Sensorfolie ein und gewährleistet so eine elektrisch leitende Verbindung zu den elektrisch leitfähigen Schichten des Kontaktfeldes. Dies kann vorzugsweise durch ein Anritzen oder Einschneiden der Oberfläche des Kontaktfeldes der Sensorfolie, um die schlecht leitenden Schichten des Kontaktfeldes zu durchstoßen, erreicht werden. In bevorzugten Ausgestaltungen des Kontaktelements kann dies durch eine Anpassung der Lage des Stanzgrates oder eine Ausbildung einer Schneid- oder Ritzkante an dem Kontaktabschnitt des elektrischen Kontaktelements erreicht werden. Alternativ oder zusätzlich kann das Kontaktfeld der Sensorfolie auch aufgerauht sein, zum Beispiel durch eine Erodierstruktur des Kontaktfeldes oder ein mechanisches Anrauhen.

Die elektrische Kontaktierung wird durch eine starre Abdeckplatte als Träger für die Sensorfolie und die vorzugsweise elastischen Kontaktelemente realisiert. Hierdurch lassen sich Vorteile bei Montagequalität, Reproduzierbarkeit und Automatisierbarkeit erzielen. Außerdem können spezielle Steckerelemente auf der Trägerplatte zum Anschließen von zum Beispiel flexiblen Kabelabgängen oder der Sensorfolie selbst entfallen.

Die Trägerplatte ist in diesem Zusammenhang vorzugsweise eine Leiterplatte oder eine Kunststoffplatte. Die Trägerplatte ist bevorzugt als ein stabiler Plattenkörper ausgebildet, kann aber auch flexibel sein und/oder nur in Folienstärke vorliegen. In einer bevorzugten Ausgestaltung der Erfindung ist auf der Trägerplatte auch eine Auswerteelektronik angeordnet, die mit dem wenigstens einen elektrischen Kontaktelement elektrisch leitend verbunden ist. In Zusammenhang mit der vorliegenden Erfindung dient die Auswerteelektronik insbesondere dem Verarbeiten und Auswerten der an dem wenigstens einen kapazitiven Sensorfeld der Sensorfolie detektierten Ausgangssignale, um ein Betätigen des Schalters (durch Berühren oder Annähern des Bedienfeldes des Bedienabschnitts der Abdeckplatte) festzustellen. Von dieser Auswerteelektronik zu unterscheiden ist die Steuerung zum Beispiel des Haushaltsgerätes, in das die Eingabevorrichtung der Erfindung eingebaut werden kann, mit welcher die Auswerteelektronik verbunden ist und welche zusammen mit der Auswerteelektronik auf der Trägerplatte oder an einer anderen Stelle im Haushaltsgerät angeordnet sein kann. In einigen Anwendungen kann die Auswerteelektronik auch bevorzugt in diese Steuerung integriert sein.

Die dem Benutzer zugewandte oder abgewandte Seite eines Bauteils soll in diesem Zusammenhang jene Seite bezeichnen, die im eingebauten Zustand der Eingabevorrichtung (zum Beispiel in einem elektronischen Haushaltsgerät) dem Benutzer zugewandt ist (d.h. nach außen zeigt) bzw. abgewandt ist (d.h. nach innen zeigt).

Je nach Anzahl der Sensorfolien und der Sensorfelder kann die Eingabevorrichtung in diesem Zusammenhang einen oder mehrere berührungs- und/oder annäherungsempfindliche Schalter mit kapazitivem Messprinzip aufweisen.

Die Sensorfolie basiert vorzugsweise auf einer Trägerfolie aus einem Kunststoffmaterial. Die Trägerfolie ist vorzugsweise aus PET, PC oder dergleichen gefertigt. Die Trägerfolie kann ein- oder mehrlagig aufgebaut sein. Die Sensorfelder und die elektrischen Kontaktfelder sind vorzugsweise auf die Trägerfolie aufgedruckt oder beschichtet (z.B. mit einer elektrisch leitfähigen Farbe, Paste oder Tinte). Der Aufdruck oder die Beschichtung ist bevorzugt ein- oder mehrlagig ausgeführt. Die Sensorfelder und die Kontaktfelder sind elektrisch leitend miteinander verbunden, vorzugsweise mittels elektrischer Verbindungsleitungen, welche vorzugsweise auf die Trägerfolie gedruckt oder beschichtet sind. Die Sensorfolie hat vorzugsweise eine Schichtdicke von höchstens 0,5 mm, bevorzugter von höchstens 0,3 mm oder weniger. Die Sensorfolie ist vorzugsweise als ein biegeschlaffes Bauteil ausgeführt. Die Sensorfolie kann so vorzugsweise der Struktur der Abdeckplatte folgen. Sensorfelder und Kontaktfelder sind vorzugsweise auf der der Abdeckplatte abgewandten Seite der Trägerfolie angeordnet, können wahlweise aber auch auf der der Abdeckplatte zugewandten Seite vorgesehen sein.

Die Abdeckplatte oder zumindest ihr Bedienabschnitt sind vorzugsweise aus einem elektrisch isolierenden Material gefertigt, sodass sie als Dielektrikum zwischen den Sensorfeldern und dem Benutzer wirkt. Alternativ ist auf der dem Benutzer zugewandten Seite der Abdeckplatte zusätzlich ein elektrisch isolierendes Element vorgesehen. Die Abdeckplatte ist vorzugsweise aus einem Kunststoffmaterial (z.B. PC, PMMA), Glas, einer Glaskeramik oder dergleichen gefertigt. Die Abdeckplatte kann - unabhängig von ihrem Material - auch als "Deckglas" bezeichnet werden. Die Abdeckplatte ist vorzugsweise als ein Spritzgussteil gefertigt. Die Abdeckplatte ist vorzugsweise ein starres, d.h. formstabiles Bauteil. Der Kontaktierungsabschnitt ist vorzugsweise starr mit dem Bedienabschnitt der Abdeckplatte verbunden. Die Abdeckplatte ist vorzugsweise ein einstückiges Bauteil. Die Abdeckplatte kann vorzugsweise in eine Bedienblende zum Beispiel eines elektronischen Haushaltsgerätes eingesetzt werden, wobei die Gestaltung insbesondere des Bedienabschnitts der Abdeckplatte der Konstruktion der Bedienblende folgt (d.h. zum Beispiel ebenfalls im Wesentlichen plan oder gebogen / gekrümmt ausgebildet ist).

Die dem Benutzer abgewandte Seite des Bedienabschnitts der Abdeckplatte wird als Sensorebene bezeichnet. Die Sensorebene bezeichnet in diesem Zusammenhang nicht unbedingt exakt die Ebene, in welcher die kapazitiven Sensorfelder der Sensorfolie liegen, sondern definiert eine Basisebene für diese. Die Sensorfelder der Sensorfolie sind vorzugsweise parallel zur Sensorebene angeordnet. Die Sensorebene ist in diesem Zusammenhang nicht notwendigerweise eine geometrische Ebene im Raum, sondern eine Fläche, welche vorzugsweise parallel zu der dem Benutzer zugewandten Außenseite der Abdeckplatte bzw. der Bedienblende verläuft. Auf diese Weise verlaufen vorzugsweise auch die kapazitiven Sensorfelder der Sensorfolie parallel zu der dem Benutzer zugewandten Außenseite der Abdeckplatte bzw. der Bedienblende. Dies gilt vorzugsweise auch bei räumlich strukturierten (d.h. gebogenen, gekrümmten, bombierten, etc.) Bedienfeldern bzw. Bedienblenden.

Die dem Benutzer abgewandte Seite des Kontaktierungsabschnitts der Abdeckplatte wird als Kontaktierungsebene bezeichnet. Die Kontaktierungsebene bezeichnet in diesem Zusammenhang nicht unbedingt exakt die Ebene, in welcher die elektrischen Kontaktfelder der Sensorfolie liegen, sondern definiert eine Basisebene für diese. Die Kontaktfelder der Sensorfolie sind vorzugsweise parallel zur Kontaktierungsebene angeordnet. Die Kontaktierungsebene ist in diesem Zusammenhang nicht notwendigerweise eine geometrische Ebene im Raum, sondern eine Fläche, welche vorzugsweise parallel zu der Trägerplatte verläuft. Auf diese Weise verlaufen vorzugsweise auch die elektrischen Kontaktfelder der Sensorfolie parallel zu der Trägerplatte, so dass hier mit einfachen elektrischen Kontaktelementen eine elektrisch leitende Verbindung zwischen Sensorik und Auswerteelektronik geschaffen werden kann. Diese elektrische Kontaktierung ist dabei unabhängig von der jeweiligen räumlichen Struktur (d.h. gebogenen, gekrümmten, bombierten, etc.) oder planen Ausgestaltung des Bedienfeldes bzw. der Bedienblende zuverlässig realisierbar. Durch die Parallelität von Kontaktierungsebene und Trägerplatte können vorzugsweise gleiche oder gleichartige Kontaktelemente eingesetzt werden, die im zusammengebauten Zustand der Eingabevorrichtung (im Wesentlichen) gleich belastet werden und hochwirtschaftlich bestückt werden können.

Die Ausrichtung der Kontaktierungsebene des Kontaktierungsabschnitts der Abdeckplatte ist bei der Eingabevorrichtung der Erfindung grundsätzlich unabhängig von der Ausrichtung der Sensorebene des Bedienabschnitts der Abdeckplatte. Je nach Ausgestaltung der Bedienblende verläuft die Kontaktierungsebene insbesondere nicht notwendigerweise parallel zur Sensorebene. Vielmehr ist die Sensorebene des Bedienabschnitts an die Bedienblende zum Beispiel des elektronischen Haushaltsgerätes angepasst, während die Kontaktierungsebene des Kontaktierungsabschnitts an die Trägerplatte der Eingabevorrichtung angepasst ist.

Das elektrische Kontaktelement bezeichnet in diesem Zusammenhang ein konstruktives Element, das geeignet ist, eine elektrisch leitende Verbindung zwischen zwei Bauteilen oder Kontaktfeldern herzustellen. Das Kontaktelement ist vorzugsweise aus einem elektrisch leitfähigen Material (vorzugsweise Metall) gebildet und/oder elektrisch leitfähig beschichtet. Das wenigstens eine elektrische Kontaktelement ist vorzugswiese in einer Richtung quer zur Kontaktierungsebene elastisch ausgestaltet und/oder angeordnet. Vorzugsweise ist das wenigstens eine elektrische Kontaktelement als ein Federelement, bevorzugt als Blattfederelement ausgestaltet. Vorzugsweise ist das wenigstens eine elektrische Kontaktelement als ein Z-, S-, C- oder spiralförmiges Federelement ausgestaltet.

In einer bevorzugten Ausgestaltung der Erfindung weist die Abdeckplatte einen Verbindungsabschnitt auf, welcher den Kontaktierungsabschnitt im Wesentlichen starr mit dem Bedienabschnitt verbindet. Der Verbindungsabschnitt kann im Wesentlichen plan ausgebildet sein, insbesondere falls die Sensorebene und die Kontaktierungsebene im Wesentlichen koplanar ausgerichtet sind. Der Verbindungsabschnitt gleicht vorzugsweise Unterschiede in der räumlichen Ausrichtung des Bedienabschnitts und des Kontaktierungsabschnitts der Abdeckplatte und/oder in deren Abständen zur Trägerplatte aus.

In einer bevorzugten Ausgestaltung der Erfindung ist dieser Verbindungsabschnitt der Abdeckplatte derart gekrümmt ausgebildet, dass die durch den Bedienabschnitt der Abdeckplatte gebildete Sensorebene und die durch den Kontaktierungsabschnitt der Abdeckplatte gebildete Kontaktierungsebene zumindest teilweise in unterschiedlichen Abständen und/oder Ausrichtungen zur Trägerplatte verlaufen. In einer anderen bevorzugten Ausgestaltung der Erfindung ist dieser Verbindungsabschnitt im Wesentlichen plan ausgestaltet.

In einer weiteren bevorzugten Ausgestaltung der Erfindung ist die Sensorfolie fest mit der dem Benutzer abgewandten Seite der Abdeckplatte verbunden. Diese feste Verbindung ist vorzugsweise dauerhaft oder lösbar ausgestaltet. Die Sensorfolie ist mit der Abdeckplatte vorzugsweise mittels Verklebung, Laminierung oder Einspritzung (bevorzugt IML, In-Mould-Labeling) verbunden. Die Abdeckplatte bildet bei dieser Ausgestaltung einen (formstabilen) Träger für die Sensorfolie.

In einer noch weiteren bevorzugten Ausgestaltung der Erfindung ist das wenigstens eine elektrische Kontaktelement mit dem wenigstens einen elektrischen Kontaktfeld der Trägerplatte fest verbunden. In einer bevorzugten Ausführungsvariante ist das elektrische Kontaktelement mit dem Kontaktfeld der Trägerplatte verlötet. In einer anderen bevorzugten Ausführungsvariante ist das elektrische Kontaktelement an die Sensorfolie bzw. an ihr Kontaktfeld integral angebunden, zum Beispiel durch Heißverstemmen, Einspritzen, Anclipsen, Aufstecken, Einpressen oder dergleichen.

In einer weiteren bevorzugten Ausgestaltung der Erfindung ist auf der Trägerplatte wenigstens eine Anzeigevorrichtung angeordnet und sind die Abdeckplatte und die Sensorfolie zumindest teilweise lichtdurchlässig ausgebildet. Durch diese Maßnahmen kann das Bedienfeld der Eingabevorrichtung hinterleuchtet werden und/oder können die Positionen der kapazitiven Sensorfeld im Bedienabschnitt der Abdeckplatte optisch gekennzeichnet / beleuchtet werden. Außerdem kann das Bedienfeld der Eingabevorrichtung bei dieser Ausgestaltung zugleich als Anzeigefeld (zum Beispiel für aktuelle Werte der eingestellten Betriebsparameter, aktuelle Betriebszustände, etc.) genutzt werden. Bei der Anzeigevorrichtung handelt es sich in diesem Zusammenhang vorzugsweise um eine einfache Leuchtdiode (LED) oder Leuchtdiodengruppe, ein LED-Display, einen TFT-Monitor, eine Flüssigkristallanzeige (LCD-Display) oder dergleichen.

Gegenstand der Erfindung ist auch ein elektronisches Haushaltsgerät mit wenigstens einer oben beschriebenen berührungs- und/oder annäherungsempfindlichen Eingabevorrichtung der Erfindung. Bei dem Haushalts(groß)gerät handelt es sich vorzugsweise um ein Wäschebehandlungsgerät (z.B. Waschmaschine, Wäschetrockner, etc.), eine Geschirrspülmaschine, ein Kochfeld, einen Herd, ein Kühl- und/oder Gefriergerät oder dergleichen.

In einer bevorzugten Ausgestaltung der Erfindung ist der Bedienabschnitt der Abdeckplatte der erfindungsgemäßen Eingabevorrichtung hinter einer zumindest teilweise lichtdurchlässigen Bedienblende oder in einer Aussparung einer Bedienblende angeordnet.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine perspektivische Draufsicht einer Eingabevorrichtung gemäß der Erfindung;
- Fig. 2: eine perspektivische Explosionsdarstellung einer Eingabevorrichtung gemäß einem ersten Ausführungsbeispiel der Erfindung;
- Fig. 3: zwei perspektivische Teilschnittansichten der Eingabevorrichtung von Fig. 2;
- Fig. 4: zwei weitere perspektivische Teilschnittansichten der Eingabevorrichtung von Fig. 2;
- Fig. 5: eine perspektivische Explosionsdarstellung einer Eingabevorrichtung gemäß einem zweiten Ausführungsbeispiel der Erfindung; und
- Fig. 6: eine perspektivische Teilschnittansicht der Eingabevorrichtung von Fig. 5.

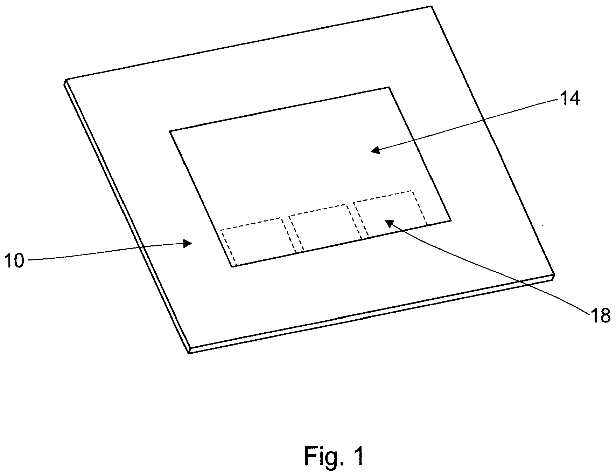

Bezug nehmend auf Fig. 1 bis 4 wird nun ein erstes Ausführungsbeispiel einer berührungs- und/oder annäherungsempfindlichen Eingabevorrichtung näher beschrieben, wie sie beispielsweise in einem Haushalts(groß)gerät wie zum Beispiel einer Waschmaschine oder einer Geschirrspülmaschine eingesetzt werden kann.

Die Eingabevorrichtung wird hinter einer Bedienblende 10 zum Beispiel aus Kunststoff oder Glaskeramik in das Haushaltsgerät eingebaut. In der Bedienblende 10 ist eine hier rechteckige Aussparung 12 vorgesehen. Anstelle der Aussparung 12 kann die Bedienblende 10 auch einen transparenten Bereich aufweisen. Die Bedienblende 10 ist in diesem Ausführungsbeispiel im Wesentlichen plan ausgestaltet, zumindest im Bereich der Eingabevorrichtung. Die dem Benutzer zugewandte (Außen-)Seite der Bedienblende 10 bzw. der Eingabevorrichtung zeigt in Fig. 1 bis 4 jeweils nach oben.

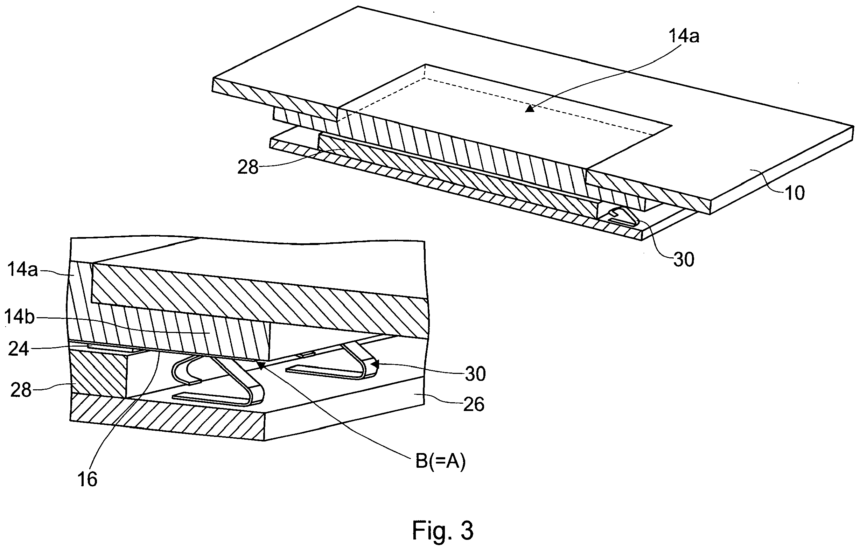

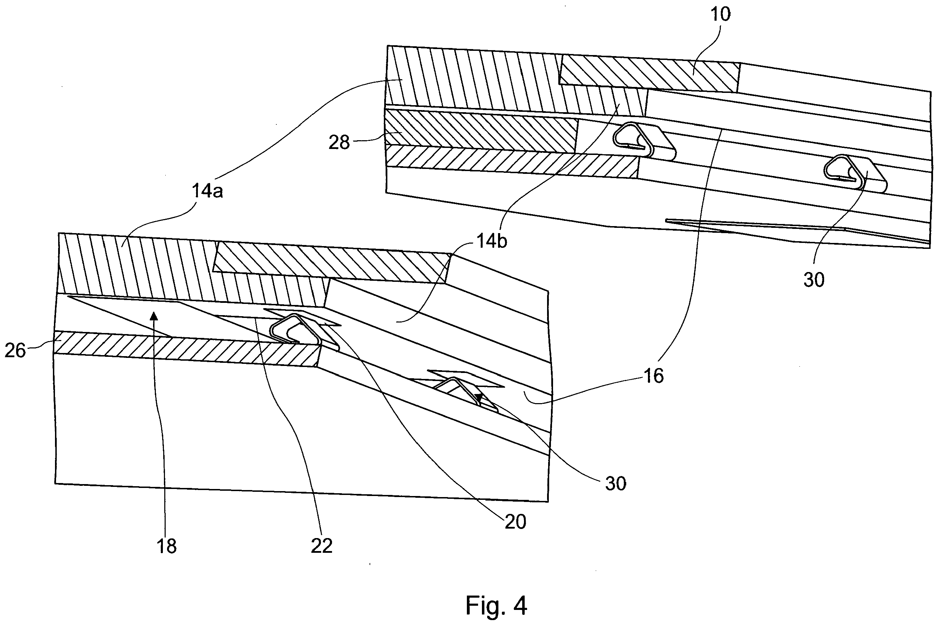

Auf der dem Benutzer abgewandten Seite der Bedienblende 10 ist eine Abdeckplatte 14 zum Beispiel aus einem transparenten, elektrisch isolierenden Kunststoff-, Glas- oder Glaskeramikmaterial angeordnet. Diese Abdeckplatte 14 weist einen im Wesentlichen planen Bedienabschnitt 14a auf. Dieser Bedienabschnitt 14a ist dicker als die übrige Abdeckplatte 14 ausgebildet und entsprechend der Aussparung 12 in der Bedienblende 10 geformt und dimensioniert, sodass er in die Aussparung 12 hinein ragt und im Wesentlichen bündig mit der Außenseite der Bedienblende 10 abschließt (vgl. Fig. 3 und 4).

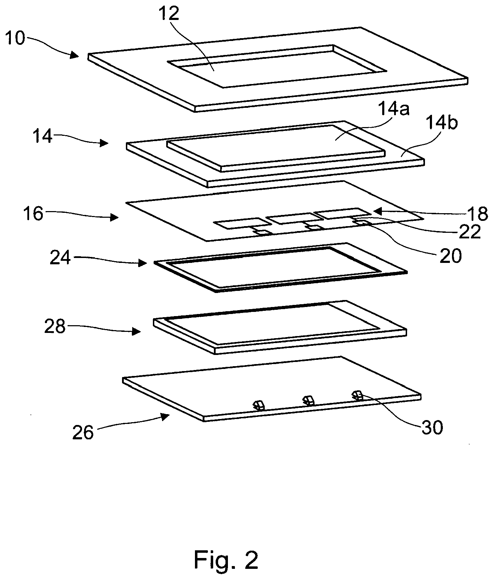

Wie in Fig. 2 bis 4 dargestellt, ist der Bedienabschnitt 14a der Abdeckplatte 14 umlaufend von einem Kontaktierungsabschnitt 14b umgeben, der mit dem Bedienabschnitt 14a verbunden oder bevorzugt einstückig mit diesem ausgebildet ist. Die Schichtdicke des Kontaktierungsabschnitts 14b ist kleiner als die Schichtdicke des Bedienabschnitts 14a der Abdeckplatte 14.

Die dem Benutzer der Eingabevorrichtung abgewandte Seite des Bedienabschnitts 14a der Abdeckplatte 14 bildet bzw. definiert eine Sensorebene A. Die dem Benutzer der Eingabevorrichtung abgewandte Seite des Kontaktierungsabschnitts 14b bildet bzw. definiert eine Kontaktierungsebene B. In diesem Ausführungsbeispiel mit der im Wesentlichen planen Bedienblende 10 sind auch der Bedienabschnitt 14a und der Kontaktierungsabschnitt 14b der Abdeckplatte 14 im Wesentlichen plan ausgestaltet. Außerdem sind in diesem Ausführungsbeispiel die Sensorebene A des Bedienabschnitts 14a und die Kontaktierungsebene B des Kontaktierungsabschnitts 14b koplanar zueinander angeordnet (A = B, vgl. Fig. 3 und 4). Bei anders gewählten Schichtdicken können die Sensorebene A und die Kontaktierungsebene B auch parallel zueinander angeordnet sein.

Die Abdeckplatte 14 ist vorzugsweise einstückig ausgebildet und bildet ein starres, d.h. formstabiles Bauteil. Sie ist zum Beispiel als Spritzgussteil herstellbar.

Die Abdeckplatte 14 ist mit der Bedienblende 10 beispielsweise verklebt und ein etwaiger Spalt zwischen dem Bedienabschnitt 14a und dem Rand der Aussparung 12 ist vorzugsweise vergossen oder verklebt.

Die beschriebene Abdeckplatte 14 dient als stabiler Träger für eine Sensorfolie 16. Die Sensorfolie 16 ist als biegeschlaffes Bauteil ausgestaltet und wird mit der dem Benutzer abgewandten Seite der Abdeckplatte 14 fest verbunden, zum Beispiel mittels eines transparenten Klebstoffes verklebt oder auf diese laminiert.

Die Sensorfolie 16 besteht im Wesentlichen aus einer transparenten Kunststofffolie (z.B. PET oder PC) als Trägerfolie. Sie ist zudem mit elektrisch leitfähigen Strukturen bedruckt, welche insbesondere kapazitive Sensorfelder 18, elektrische Kontaktfelder 20 und elektrische Verbindungsleitungen 22 dazwischen bilden. Diese sind vorzugsweise auf der der Abdeckplatte 14 abgewandten Seite der Sensorfolie 16 vorgesehen. Während die kapazitiven Sensorfelder 18 im Bereich des Bedienabschnitts 14a der Abdeckplatte 14 parallel zur Sensorebene A positioniert sind, sind die elektrischen Kontaktfelder 20 im Bereich des Kontaktierungsabschnitts 14b der Abdeckplatte 14 parallel zur Kontaktierungsebene B vorgesehen. In der Regel ist jeweils ein Sensorfeld 18 über eine elektrische Verbindungsleitung 22 mit einem Kontaktfeld 20 elektrisch leitend verbunden. Je nach Anwendung können ein oder mehrere Sensorfelder 18 vorgesehen sein, um dem Benutzer ein oder mehrere Bedienelemente bereitzustellen.

Jedes kapazitive Sensorfeld 18 bildet zusammen mit zum Beispiel einem Finger des Benutzers über die Abdeckplatte 14 bzw. ihren Bedienabschnitt 14a als Dielektrikum eine Kapazität, die entsprechend dem Betätigen der Eingabevorrichtung, d.h. dem Berühren oder Nicht-Berühren bzw. dem Annähern oder Nicht-Annähern des Bedienabschnitts 14a der Abdeckplatte 14 variabel ist. Die Veränderung des Kapazitätswertes des kapazitiven Sensorfeldes 18 kann an dem mit diesem Sensorfeld 18 verbundenen Kontaktfeld 20 der Sensorfolie 16 abgegriffen und durch eine geeignete Auswerteelektronik verarbeitet und ausgewertet werden. Die Auswerteelektronik ist wiederum mit einer Gerätesteuerung verbunden oder in eine solche integriert.

Die Auswerteelektronik ist beispielsweise auf einer Trägerplatte 26 angeordnet. Im Fall der planen Bedienblende 10 ist diese Trägerplatte 26 im Wesentlichen parallel zur Bedienblende 10 ausgerichtet. Auf der der Bedienblende 10 zugewandten Seite der Trägerplatte 26 sind mehrere elektrische Kontaktfelder ausgebildet.

Über baugleiche, C-förmige Blattfederelemente 30 aus einem elektrisch leitfähigen Material (z.B. Metall) sind die elektrischen Kontaktfelder 20 der Sensorfolie 16 (und damit auch die kapazitiven Sensorfelder 18 der Sensorfolie 16) mit den elektrischen Kontaktfeldern der Trägerplatte 26 elektrisch leitend verbunden. Im zusammengebauten Zustand der Eingabevorrichtung (vgl. Fig. 3 und 4) sind die als Blattfedern ausgestalteten elektrischen Kontaktelemente 30 leicht zusammengedrückt, sodass sie über ihre Federkraft einen guten elektrischen Kontakt zu den elektrischen Kontaktfeldern der Sensorfolie 16 und der Trägerplatte 26 bilden.

In einer Ausführungsvariante ist das elektrische Kontaktelement 30 mit dem elektrischen Kontaktfeld der Trägerplatte 26 verlötet. In einem nicht erfindungsgemäßen Beispiel ist das elektrische Kontaktelement 30 an die Sensorfolie 16 bzw. an ihr elektrisches Kontaktfeld 20 in integraler Weise angebunden, zum Beispiel durch Heißverstemmen, Einspritzen, Anclipsen, Aufstecken, Einpressen oder dergleichen.

Gemäß der Erfindung können die elektrischen Kontaktelemente 30 mit den elektrischen Kontaktfeldern der Trägerplatte 26 verlötet sein und weisen an ihrer den elektrischen Kontaktfeldern 20 der Sensorfolie 16 zugewandten Seite jeweils einen Kontaktabschnitt auf, der so ausgestaltet ist, dass er im zusammengebauten Zustand der Eingabevorrichtung in das jeweilige elektrische Kontaktfeld 20 der Sensorfolie 16 zumindest teilweise eindringt. Beispielsweise ist die Lage des Stanzgrates entsprechend angepasst oder eine Schneid- oder Ritzkante an dem Kontaktabschnitt des elektrischen Kontaktelements 30 ausgebildet. Alternativ oder zusätzlich kann das elektrische Kontaktfeld 20 der Sensorfolie 16 auch aufgerauht sein, zum Beispiel durch eine Erodierstruktur des Kontaktfeldes 20 oder ein mechanisches Anrauhen.

Mit einer solchen Ausgestaltung des elektrischen Kontaktelements 30 dringt dieses im zusammengebauten Zustand der Eingabevorrichtung aufgrund der Federkraft des elektrisch leitenden Kontaktelements 30 zumindest teilweise in das elektrische Kontaktfeld 20 der Sensorfolie ein und gewährleistet so eine elektrisch leitende Verbindung zu den elektrisch leitfähigen Schichten des Kontaktfeldes, indem es die Oberfläche des Kontaktfeldes 20 der Sensorfolie 16 einschneidet oder anritzt, um die ggf. schlecht leitenden Schichten des Kontaktfeldes 20 zu durchstoßen.

Wie vorstehend erläutert und in Fig. 2 bis 4 veranschaulicht, ist der Kontaktierungsabschnitt 14b der Abdeckplatte 14 außerhalb der Aussparung 12 in der Bedienblende 10 neben dem Bedienabschnitt 14a der Abdeckplatte 14 positioniert. In entsprechender Weise sind die kapazitiven Sensorfelder 18 der Sensorfolie 16 im Bereich des Bedienabschnitts 14a der Abdeckplatte 14 angeordnet, während die elektrischen Kontaktfelder 20 der Sensorfolie 16 im Bereich des Kontaktierungsabschnitts 14b der Abdeckplatte 14 neben der Aussparung 12 in der Bedienblende 10 angeordnet sind. Die elektrischen Kontaktelemente 30 zur elektrisch leitenden Verbindung der elektrischen Kontaktfelder 20 der Sensorfolie 16 mit den elektrischen Kontaktfeldern der Trägerplatte 26 sind dementsprechend ebenfalls außerhalb der Aussparung 12 in der Bedienblende 10 angeordnet. Die Positionsangaben "außerhalb" und "neben" beziehen sich dabei jeweils auf eine Richtung in der Raumebene der Sensorebene A.

Durch diese spezielle Ausgestaltung der Eingabevorrichtung können die Funktionalitäten der Sensorik einerseits und der elektrischen Kontaktierung andererseits räumlich getrennt werden. Hierdurch lässt sich die Sensorik optimal an die jeweilige Bedienblende 10 anpassen. Insbesondere können die kapazitiven Sensorfelder 18 der Sensorfolie 16 bei beliebigen räumlichen Strukturen der Bedienblende im Wesentlichen parallel zu deren Außenseite verlaufen und damit eine gute und gleichmäßige Signalausbeute ermöglichen. Hierzu muss lediglich der Bedienabschnitt 14a der Abdeckplatte 14 entsprechend geformt sein. Unabhängig davon kann die Kontaktierungsebene B im Wesentlichen parallel zur Trägerplatte 26 ausgerichtet sein, was eine einfache und zuverlässige elektrische Kontaktierung der Sensorfelder 18 über die Kontaktfelder 20 der Sensorfolie 16 auch mit einfachen Kontaktelementen 30 erlaubt.

Wie in Fig. 2 bis 4 dargestellt, ist auf der Trägerplatte 26 im Bereich des Bedienabschnitts 14a der Abdeckplatte 14 zudem eine Anzeigevorrichtung 28 in Form zum Beispiel einer LED-, LCD- oder TFT-Anzeige angeordnet. Zwischen der der Abdeckplatte 14 zugewandten Oberseite der Anzeigevorrichtung 28 und der Sensorfolie 16 ist ein Abstands- und Dichtelement 24 aus einem elektrisch nicht leitenden Material angeordnet.

Um die optische Anzeige und/oder Beleuchtung, die durch diese Anzeigevorrichtung 28 zur Verfügung gestellt werden, sehen zu können, sind die Sensorfolie 16 und zumindest der Bedienabschnitt 14a der Abdeckplatte 14 zumindest teilweise lichtdurchlässig ausgestaltet.

Obwohl nicht dargestellt, können optional Dekorelemente zum Beispiel zum Kennzeichnen der durch die kapazitiven Sensorfelder 18 der Sensorfolie 16 gebildeten Bedienfelder der Eingabevorrichtung vorgesehen sein. Die Dekorelemente sind zum Beispiel durch eine zumindest teilweise lichtdurchlässige Dekorfolie gebildet. Eine solche Dekorfolie kann beispielsweise mit der Anzeigevorrichtung 28, der Sensorfolie 16 oder der Abdeckplatte 14 fest verbunden, zum Beispiel verklebt sein. Alternativ können die optischen Dekorelemente auch in die Sensorfolie 16 mit integriert sein.

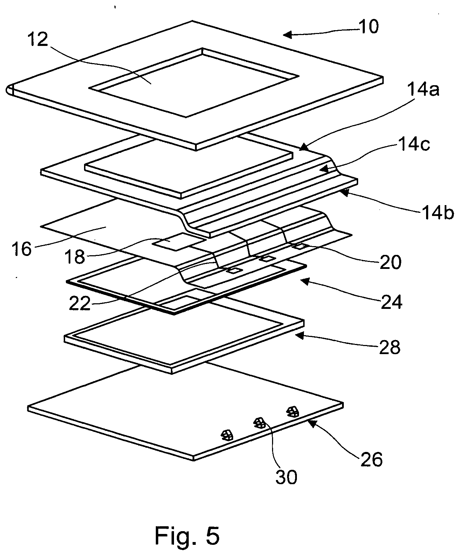

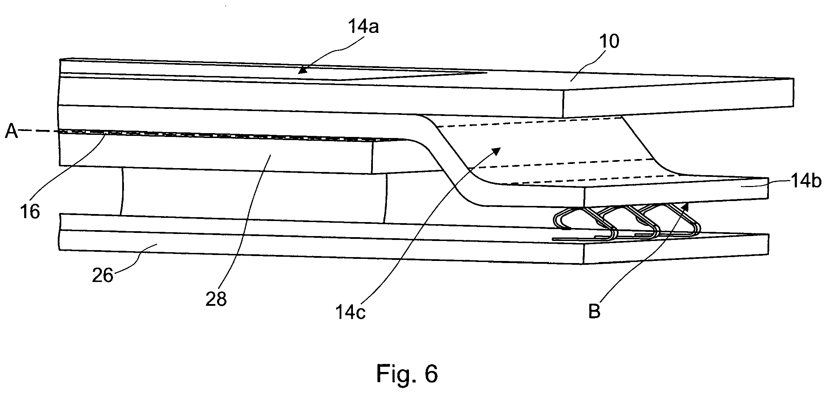

Bezug nehmend auf Fig. 5 und 6 wird nun ein zweites Ausführungsbeispiel einer berührungs- und/oder annäherungsempfindlichen Eingabevorrichtung näher beschrieben, wie sie beispielsweise in einem Haushalts(groß)gerät wie zum Beispiel einer Waschmaschine oder einer Geschirrspülmaschine eingesetzt werden kann. Dabei sind gleiche bzw. entsprechende Komponenten mit den gleichen Bezugsziffern wie im ersten Ausführungsbeispiel gekennzeichnet.

Bei diesem zweiten Ausführungsbeispiel wird die Trennung der Funktionalitäten der Sensorik und der elektrischen Kontaktierung der erfindungsgemäßen Eingabevorrichtung noch deutlicher.

Das in Fig. 5 und 6 veranschaulichte Ausführungsbeispiel der Eingabevorrichtung unterscheidet sich von dem ersten Ausführungsbeispiel der Fig. 1 bis 4 insbesondere dadurch, dass die Sensorebene A und die Kontaktierungsebene B nicht koplanar zueinander verlaufen.

Dies wird insbesondere durch eine spezielle Ausgestaltung der Abdeckplatte 14 erreicht. Der Bedienabschnitt 14a der Abdeckplatte 14, der die Sensorebene A bildet, und der Kontaktierungsabschnitt 14b der Abdeckplatte 14, der die Kontaktierungsebene B bildet, verlaufen nicht in einer gemeinsamen Ebene, sondern in unterschiedlichen Abständen zur Trägerplatte 26 (vgl. Fig. 6) und/oder in unterschiedlichen Orientierungen zur Trägerplatte 26. Der Bedienabschnitt 14a und der Kontaktierungsabschnitt 14b der Abdeckplatte 14 sind dabei durch einen starren Verbindungsabschnitt 14c der Abdeckplatte 14 integral miteinander verbunden. Der Verbindungsabschnitt 14c verläuft dabei vorzugsweise mehrfach gekrümmt, gekröpft, verdrillt, verdreht oder dergleichen geformt zwischen den beiden anderen Abschnitten 14a, 14b der Abdeckplatte 14.

Die Sensorfolie 16 passt sich als biegeschlaffes Bauteil problemlos der Gestaltung der Abdeckplatte 14 an.

Die Bedienblende 10 ist auch in diesem Ausführungsbeispiel im Wesentlichen plan ausgebildet. Dementsprechend ist auch der Bedienabschnitt 14a der Abdeckplatte 14 im Wesentlichen plan ausgebildet. Besondere Vorteile dieser Ausführungsform ergeben sich aber auch bei räumlich strukturierten (z.B. gebogenen, bombierten, etc.) Bedienblenden 10, in welchem Fall der Bedienabschnitt 14a der Abdeckplatte 14 an diese Struktur angepasst ist. Der Kontaktierungsabschnitt 14b der Abdeckplatte 14 ist auch in diesem Fall im Wesentlichen plan ausgestaltet und verläuft im Wesentlichen parallel zur Trägerplatte 26.

Im Übrigen entsprechen die Komponenten der Eingabevorrichtung der Fig. 5 und 6 jenen des ersten Ausführungsbeispiels.

### BEZUGSZIFFERNLISTE

- 10: Bedienblende
- 12: Aussparung
- 14: Abdeckplatte
- 14a: Bedienabschnitt
- 14b: Kontaktierungsabschnitt
- 14c: Verbindungsabschnitt
- 16: Sensorfolie
- 18: kapazitives Sensorfeld
- 20: elektrisches Kontaktfeld
- 22: elektrische Verbindungsleitung
- 24: Abstandselement
- 26: Trägerplatte
- 28: Anzeigevorrichtung
- 30: elektrisches Kontaktelement
- A: Sensorebene
- B: Kontaktierungsebene

## Patentansprüche

1. Berührungs- und/oder annäherungsempfindliche Eingabevorrichtung, insbesondere für ein elektronisches Haushaltsgerät, aufweisend:
eine Abdeckplatte (14) mit einem Bedienabschnitt (14a), wobei eine einem Benutzer der Eingabevorrichtung zugewandte Seite des Bedienabschnitts (14a) ein Bedienfeld für den Benutzer und eine dem Benutzer abgewandte Seite des Bedienabschnitts (14a) eine Sensorebene (A) bildet;
wenigstens ein kapazitives Sensorfeld (18), welches in einer Richtung senkrecht zur Sensorebene (A) auf einer dem Benutzer abgewandten Seite der Abdeckplatte (14) im Bereich des Bedienabschnitts (14a) der Abdeckplatte (14) angeordnet ist;
eine Trägerplatte (26), welche in einer Richtung senkrecht zur Sensorebene (A) auf einer dem Benutzer abgewandten Seite des wenigstens einen Sensorfeldes (18) angeordnet ist und auf welcher wenigstens ein elektrisches Kontaktfeld vorgesehen ist; und
wenigstens ein elektrisches Kontaktelement (30), welches zwischen der Trägerplatte (26) und dem wenigstens einen Sensorfeld (18) angeordnet ist, um das wenigstens eine Sensorfeld (18) elektrisch leitend mit dem wenigstens einen elektrischen Kontaktfeld der Trägerplatte (26) zu verbinden,
wobei die Abdeckplatte (14) einen Kontaktierungsabschnitt (14b) aufweist, der in einer Richtung der Sensorebene (A) neben dem Bedienabschnitt (14a) angeordnet ist und dessen dem Benutzer abgewandte Seite eine Kontaktierungsebene (B) bildet;
wobei ferner wenigstens ein elektrisches Kontaktfeld (20) vorgesehen ist, welches in einer Richtung der Sensorebene (A) neben dem wenigstens einen Sensorfeld (18) im Bereich des Kontaktierungsabschnitts (14b) der Abdeckplatte (14) angeordnet ist und elektrisch leitend mit dem wenigstens einen Sensorfeld (18) verbunden ist, und wobei das wenigstens eine elektrische Kontaktelement (30) das wenigstens eine elektrische Kontaktfeld (20) elektrisch leitend mit dem wenigstens einen elektrischen Kontaktfeld der Trägerplatte (26) verbindet,
**dadurch gekennzeichnet, dass**
das wenigstens eine kapazitive Sensorfeld (18) und das wenigstens eine elektrische Kontaktfeld (20) auf einer Sensorfolie (16) vorgesehen sind, welche in einer Richtung senkrecht zur Sensorebene (A) zwischen der Abdeckplatte (14) und der Trägerplatte (26) angeordnet ist;
die durch den Kontaktierungsabschnitt (14b) der Abdeckplatte (14) gebildete Kontaktierungsebene (B) parallel zur Trägerplatte (26) verläuft, und
das wenigstens eine elektrische Kontaktelement (30) an seiner dem wenigstens einen elektrischen Kontaktfeld (20) der Sensorfolie (16) zugewandten Seite einen Kontaktabschnitt aufweist, der ausgestaltet ist, um in das wenigstens eine elektrische Kontaktfeld (20) der Sensorfolie (16) zumindest teilweise einzudringen und so eine elektrisch leitende Verbindung zu den elektrisch leitfähigen Schichten des aus leitfähigem Kunststoff gespritzten Kontaktfelds (20) zu gewährleisten.

2. Eingabevorrichtung nach Anspruch 1,
**dadurch gekennzeichnet, dass**
die durch den Bedienabschnitt (14a) der Abdeckplatte (14) gebildete Sensorebene (A) im Wesentlichen parallel zum Bedienfeld verläuft.

3. Eingabevorrichtung nach einem der vorhergehenden Ansprüche,
**dadurch gekennzeichnet, dass**
die Abdeckplatte (14) einen Verbindungsabschnitt (14c) aufweist, welcher den Kontaktierungsabschnitt (14b) im Wesentlichen starr mit dem Bedienabschnitt (14a) verbindet.

4. Eingabevorrichtung nach Anspruch 3,
**dadurch gekennzeichnet, dass**
der Verbindungsabschnitt (14c) der Abdeckplatte (14) derart gekrümmt ausgebildet ist, dass die durch den Bedienabschnitt (14a) der Abdeckplatte (14) gebildete Sensorebene (A) und die durch den Kontaktierungsabschnitt (14b) der Abdeckplatte (14) gebildete Kontaktierungsebene (B) zumindest teilweise in unterschiedlichen Abständen und/oder Ausrichtungen zur Trägerplatte (26) verlaufen.

5. Eingabevorrichtung nach einem der vorhergehenden Ansprüche,
**dadurch gekennzeichnet, dass**
die Sensorfolie (16) fest mit der dem Benutzer abgewandten Seite der Abdeckplatte (14) verbunden ist.

6. Eingabevorrichtung nach einem der vorhergehenden Ansprüche,
**dadurch gekennzeichnet, dass**
das wenigstens eine elektrische Kontaktelement (30) in einer Richtung quer zur Kontaktierungsebene (B) elastisch ausgestaltet und/oder angeordnet ist.

7. Eingabevorrichtung nach einem der vorhergehenden Ansprüche,
**dadurch gekennzeichnet, dass**
das wenigstens eine elektrische Kontaktelement (30) mit dem wenigstens einen elektrischen Kontaktfeld der Trägerplatte (26) fest verbunden ist.

8. Eingabevorrichtung nach einem der vorhergehenden Ansprüche,
**dadurch gekennzeichnet, dass**
auf der Trägerplatte (26) wenigstens eine Anzeigevorrichtung (28) angeordnet ist; und
die Abdeckplatte (14) und die Sensorfolie (16) zumindest teilweise lichtdurchlässig ausgebildet sind.

9. Elektronisches Haushaltsgerät mit wenigstens einer berührungs- und/oder annäherungsempfindlichen Eingabevorrichtung nach einem der vorhergehenden Ansprüche.

10. Elektronisches Haushaltsgerät nach Anspruch 9,
**dadurch gekennzeichnet, dass**
der Bedienabschnitt (14b) der Abdeckplatte (14) der Eingabevorrichtung hinter einer zumindest teilweise lichtdurchlässigen Bedienblende (10) oder in einer Aussparung (12) einer Bedienblende (10) angeordnet ist.

## Claims

1. Touch- and/or proximity-sensitive input device, in particular for an electronic household appliance, having:
a cover plate (14) with a control section (14a), wherein a side of the control section (14a) facing a user of the input device forms a control field for the user, and a side of the control section (14a) facing away from the user forms a sensor plane (A);
at least one capacitive sensor field (18) which in a direction perpendicular to the sensor plane (A) is arranged on a side of the cover plate (14) which faces away from the user in the region of the control section (14a) of the cover plate (14);
a carrier plate (26) which in a direction perpendicular to the sensor plane (A) is arranged on a side of the at least one sensor field (18) which faces away from the user and on which at least one electric contact field is provided;
and
at least one electric contact element (30) which is arranged between the carrier plate (26) and the at least one sensor field (18) in order to connect the at least one sensor field (18) electrically conductively to the at least one electric contact field of the carrier plate (26), wherein the cover plate (14) has a contacting section (14b) which is arranged in one direction of the sensor plane (A) next to the control section (14a) and that side of which which faces away from the user forms a contacting plane (B);
wherein furthermore at least one electric contact field (20) is provided which is arranged in one direction of the sensor plane (A) next to the at least one sensor field (18) in the region of the contacting section (14b) of the cover plate (14) and is connected electrically conductively to the at least one sensor field (18); and
wherein the at least one electric contact element (30) connects the at least one electric contact field (20) electrically conductively to the at least one electric contact field of the carrier plate (26),
**characterized in that**
the at least one capacitive sensor field (18) and the at least one electric contact field (20) are provided on a sensor film (16) which in a direction perpendicular to the sensor plane (A) is arranged between the cover plate (14) and the carrier plate (26) ;
the contacting plane (B) formed by the contacting section (14b) of the cover plate (14) extends parallel to the carrier plate (26), and
the at least one electric contact element (30) has, on its side facing the at least one electric contact field (20) of the sensor film (16), a contact section which is designed in order to penetrate at least partially into the at least one electric contact field (20) of the sensor film (16) and thus ensure an electrically conductive connection to the electrically conductive layers of the contact field (20) injection-moulded from conductive plastic.

2. Input device according to Claim 1, **characterized in that** the sensor plane (A) formed by the control section (14a) of the cover plate (14) extends essentially parallel to the control field.

3. Input device according to one of the preceding claims,
**characterized in that**
the cover plate (14) has a connecting section (14c) which connects the contacting section (14b) essentially rigidly to the control section (14a).

4. Input device according to Claim 3,
**characterized in that**
the connecting section (14c) of the cover plate (14) has a curved design such that the sensor plane (A) formed by the control section (14a) of the cover plate (14), and the contacting plane (B) formed by the contacting section (14b) of the cover plate (14) extend at least partially at different distances and/or orientations with respect to the carrier plate (26).

5. Input device according to one of the preceding claims,
**characterized in that**
the sensor film (16) is firmly connected to that side of the cover plate (14) facing away from the user.

6. Input device according to one of the preceding claims,
**characterized in that**
the at least one contact electric contact element (30) is designed and/or is arranged so that it is elastic in a direction transverse to the contacting plane (B).

7. Input device according to one of the preceding claims,
**characterized in that**
the at least one electric contact element (30) is firmly connected to the at least one electric contact field of the carrier plate (26).

8. Input device according to one of the preceding claims,
**characterized in that**
at least one display device (28) is arranged on the carrier plate (26); and
the cover plate (14) and
the sensor film (16) are designed to be at least partially transparent.

9. Electronic household appliance with at least one touch- and/or proximity-sensitive input device according to one of the preceding claims.

10. Electronic household appliance according to Claim 9,
**characterized in that**
the control section (14b) of the cover plate (14) of the input device is arranged behind an at least partially transparent control panel (10) or in a recess (12) of a control panel (10).

## Revendications

1. Dispositif de saisie tactile et/ou sensible à l'approche, notamment pour un appareil ménager électronique, comprenant :
une plaque de protection (14) munie d'une portion d'opération (14a), un côté de la portion d'opération (14a) qui fait face à un utilisateur du dispositif de saisie formant un champ d'opération pour l'utilisateur et un côté de la portion d'opération (14a) qui se trouve à l'opposé de l'utilisateur formant un plan de détection (A) ;
au moins un champ de détection capacitif (18), lequel est disposé sur un côté de la plaque de protection (14) qui se trouve à l'opposé de l'utilisateur dans une direction perpendiculaire au plan de détection (A) dans la zone de la portion d'opération (14a) de la plaque de protection (14) ;
une plaque porteuse (26), laquelle est disposée sur un côté de l'au moins un champ de détection (18) qui se trouve à l'opposé de l'utilisateur dans une direction perpendiculaire au plan de détection (A) et sur laquelle se trouve au moins un champ de contact électrique ; et
au moins un élément de contact électrique (30), qui est disposé entre la plaque porteuse (26) et l'au moins un champ de détection (18) en vue de relier de manière électriquement conductrice l'au moins un champ de détection (18) à l'au moins un champ de contact électrique de la plaque porteuse (26),
la plaque de protection (14) possédant une portion de mise en contact (14b) qui, dans une direction du plan de détection (A), est disposée à côté de la portion d'opération (14a) et dont le côté qui se trouve à l'opposé de l'utilisateur forme un plan de mise en contact (B) ;
au moins un champ de contact électrique (20) étant en outre prévu, lequel, dans une direction du plan de détection (A), est disposé à côté de l'au moins un champ de détection (18) dans la zone de la portion de mise en contact (14b) de la plaque de protection (14) et est relié de manière électriquement conductrice à l'au moins un champ de détection (18), et
l'au moins un élément de contact électrique (30) reliant de manière électriquement conductrice l'au moins un champ de contact électrique (20) à l'au moins un champ de contact électrique de la plaque porteuse (26),
**caractérisé en ce que**
l'au moins un champ de détection capacitif (18) et l'au moins un champ de contact électrique (20) se trouvent sur un film capteur (16) qui, dans une direction perpendiculaire au plan de détection (A), est disposé entre la plaque de protection (14) et la plaque porteuse (26) ;
le plan de mise en contact (B) formé par la portion de mise en contact (14b) de la plaque de protection (14) s'étend parallèlement à la plaque porteuse (26) ; et
l'au moins un élément de contact électrique (30) possède, sur son côté qui fait face à l'au moins un champ de contact électrique (20) du film capteur (16), une portion de contact qui est configurée pour pénétrer au moins partiellement dans l'au moins un champ de contact électrique (20) du film capteur (16) et garantir ainsi une liaison électriquement conductrice avec les couches électriquement conductrices du champ de contact (20) extrudé à partir de matière plastique conductrice.

2. Dispositif de saisie selon la revendication 1, **caractérisé en ce que** le plan de détection (A) formé par la portion d'opération (14a) de la plaque de protection (14) s'étend sensiblement parallèlement au champ d'opération.

3. Dispositif de saisie selon l'une des revendications précédentes, **caractérisé en ce que** la plaque de protection (14) possède une portion de liaison (14c) qui relie la portion de mise en contact (14b) de manière sensiblement rigide avec la portion d'opération (14a).

4. Dispositif de saisie selon la revendication 3, **caractérisé en ce que** la portion de liaison (14c) de la plaque de protection (14) est de configuration courbe de telle sorte que le plan de détection (A) formé par la portion d'opération (14a) de la plaque de protection (14) et le plan de mise en contact (B) formé par la portion de mise en contact (14b) de la plaque de protection (14) s'étendent au moins partiellement à des écarts et/ou selon des orientations différentes par rapport à la plaque porteuse (26).

5. Dispositif de saisie selon l'une des revendications précédentes, **caractérisé en ce que** le film capteur (16) est relié à demeure au côté de la plaque de protection (14) qui se trouve à l'opposé de l'utilisateur.

6. Dispositif de saisie selon l'une des revendications précédentes, **caractérisé en ce que** l'au moins un élément de contact électrique (30) est configuré et/ou disposé de manière élastique dans une direction transversale par rapport au plan de mise en contact (B).

7. Dispositif de saisie selon l'une des revendications précédentes, **caractérisé en ce que** l'au moins un élément de contact électrique (30) est relié à demeure à l'au moins un champ de contact électrique de la plaque porteuse (26).

8. Dispositif de saisie selon l'une des revendications précédentes, **caractérisé en ce qu'**au moins un dispositif d'affichage (28) est disposé sur la plaque porteuse (26) ;
et
la plaque de protection (14) et le film capteur (16) sont réalisés au moins partiellement de façon transparente.

9. Appareil ménager électronique équipé d'au moins un dispositif de saisie tactile et/ou sensible à l'approche selon l'une des revendications précédentes.

10. Appareil ménager électronique selon la revendication 9, **caractérisé en ce que** la portion d'opération (14b) de la plaque de protection (14) du dispositif de saisie est disposée derrière un panneau d'opération (10) au moins partiellement transparent ou dans une cavité (12) d'un panneau d'opération (10).
